# EUROPEAN PATENT APPLICATION

(11) **EP 4 768 926 A1**
(43) Date of publication of application: **01.07.2026**
(21) Application number: 24881578.9
(22) Date of filing: 22.10.2024
(51) Int. Cl.: G01R 31/12

(54) **ARC FAULT DETECTION METHOD, DIRECT-CURRENT VOLTAGE CONVERTER, AND ENERGY STORAGE DEVICE**

(30) Priority: 26.10.2023 CN 202311408924
(71) Applicant: ECOFLOW INC., Guangdong 518000 (CN)
(72) Inventor: GUO, Dongliang, Shenzhen, Guangdong 518000 (CN); WU, Dong, Shenzhen, Guangdong 518000 (CN); CHEN, Xi, Shenzhen, Guangdong 518000 (CN); WANG, Lei, Shenzhen, Guangdong 518000 (CN)
(74) Representative: Appelt, Christian W.
(86) International application number: PCT/CN2024/126311
(87) International publication number: WO 2025/087213

(57) **Abstract**

An arc fault detection method, comprising: acquiring a current signal of a direct-current conversion circuit (S110); performing frequency domain analysis on the current signal to obtain frequency spectrum information of the current signal, the frequency spectrum information comprising amplitudes of a plurality of frequency points (S120); calculating a first characteristic quantity on the basis of the amplitudes of the frequency points in the frequency spectrum information corresponding to the switching frequency of switching transistors (S130); calculating a second characteristic quantity on the basis of the amplitudes of the frequency points in the frequency spectrum information within a preset target frequency band (S140); and determining an arc fault detection result of the direct-current conversion circuit on the basis of the first characteristic quantity and the second characteristic quantity (S150).

## Description

### CROSS-REFERENCE TO RELATED APPLICATIONS

This application claims priority to Chinese Patent Application No. 202311408924.0, filed with the China National Intellectual Property Administration on October 26, 2023 and entitled "ARC FAULT DETECTION METHOD, DIRECT CURRENT VOLTAGE CONVERTER, AND ENERGY STORAGE DEVICE", which is incorporated herein by reference in its entirety.

### TECHNICAL FIELD

This application relates to the field of electronic technologies, and specifically, to an arc fault detection method, a direct current voltage converter, and an energy storage device.

### BACKGROUND

The description herein provides only background information related to this application, but does not necessarily constitute an exemplary technology.

An arc fault is a common fault type in a photovoltaic system, usually caused by poor contact due to line aging or a loose cable joint. A direct current arc has high conductivity and can generate temperatures exceeding 3000°C, which may easily cause an electric shock, equipment damage, or a fire hazard. Therefore, detecting whether an arc is generated on the direct current side of the photovoltaic system is crucial for the photovoltaic system.

The related technology mainly involves transforming a detected direct current from a time domain into a frequency domain through fast Fourier transform to obtain a current spectrum, and analyzing a harmonic amplitude of the direct current. If the harmonic amplitude exceeds a preset threshold, it can be determined that an arc fault has occurred. However, the direct current side of the photovoltaic system is usually provided with an input switch. If the input switch is a switch involving a mechanical action, such as a relay, a current spectrum of the direct current during switching of the input switch is similar to a current spectrum during an arc fault, which may easily lead to false detection of generation of an arc during switching of the input switch.

### SUMMARY

According to various embodiments of this application, an arc fault detection method, a direct current voltage converter, and an energy storage device are provided.

A first aspect of this application provides an arc fault detection method for a direct current conversion circuit, where the direct current conversion circuit includes a switching transistor; and the arc fault detection method includes: obtaining a current signal of the direct current conversion circuit; performing frequency domain analysis on the current signal to obtain spectrum information of the current signal, where the spectrum information includes amplitudes of a plurality of frequency points; calculating a first feature quantity based on the amplitude of the frequency point in the spectrum information that corresponds to a switching frequency of the switching transistor; calculating a second feature quantity based on the amplitude of the frequency point in the spectrum information that is located within a preset target frequency band; and determining an arc fault detection result of the direct current conversion circuit based on the first feature quantity and the second feature quantity.

A second aspect of this application provides a direct current voltage converter, including a direct current conversion circuit and a controller, where the direct current conversion circuit includes a switching transistor, and the controller is configured to perform the arc fault detection method described above.

A third aspect of this application provides an energy storage device, including an energy storage battery, an input switch, and the direct current voltage converter described above, where an input terminal of the direct current voltage converter is connected to an input power supply through the input switch, the input power supply is configured to provide a direct current to the direct current voltage converter, the energy storage battery is connected to an output terminal of the direct current voltage converter, and the direct current voltage converter is configured to perform voltage conversion on the direct current before outputting the direct current.

A fourth aspect provides a computer-readable storage medium, storing a computer program, where the computer program, when executed by a controller, causes the arc fault detection method described above to be implemented.

Details of one or more embodiments of this application are provided in accompanying drawings and descriptions below. Other features, objectives, and advantages of this application are to become apparent from the specification, the accompanying drawings, and the claims.

### BRIEF DESCRIPTION OF THE DRAWINGS

To describe technical solutions in embodiments of this application or exemplary technologies more clearly, the following briefly describes accompanying drawings required for describing the embodiments or the exemplary technologies. Apparently, the accompanying drawings in the following descriptions show merely some embodiments of this application, and a person of ordinary skill in the art may still derive drawings of other embodiments from these accompanying drawings without creative efforts.
FIG. 1 is a schematic module diagram of an energy storage device according to an embodiment of this application;
FIG. 2 is a schematic module diagram of an energy storage device according to another embodiment of this application;
FIG. 3 is a schematic module diagram of a direct current voltage converter according to an embodiment of this application;
FIG. 4 is a schematic diagram of a circuit structure of a direct current conversion circuit according to an embodiment of this application;
FIG. 5 is a flowchart of an arc fault detection method according to an embodiment of this application;
FIG. 6 is a detailed flowchart of step S120 in FIG. 5;
FIG. 7 is a schematic diagram of a spectrum curve according to an embodiment of this application;
FIG. 8 is a schematic diagram of another spectrum curve according to an embodiment of this application;
FIG. 9 is a detailed flowchart of step S130 in FIG. 5; and
FIG. 10 is a detailed flowchart of step S140 in FIG. 5.

### DETAILED DESCRIPTION

It should be noted that, in the specification, claims, and the accompanying drawings of this application, the terms "first" and "second" are intended to distinguish between similar objects instead of describing a specific order or sequence.

In addition, it should be noted that, the method disclosed in the embodiments of this application or the method shown in the flowchart includes one or more steps for implementing the method. Without departing from the scope of the claims, the execution order of the plurality of steps may be interchanged, where some steps may alternatively be deleted.

The following describes some embodiments with reference to the accompanying drawings. The following embodiments and features in the embodiments may be mutually combined if no conflict occurs.

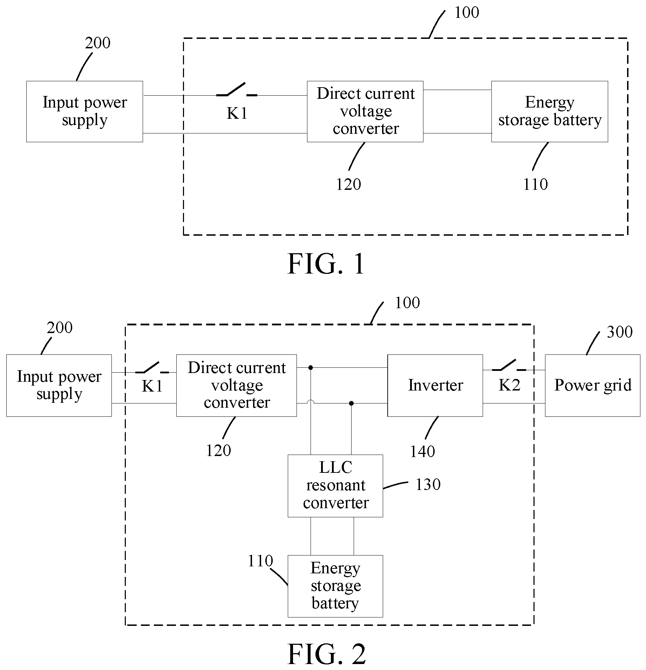

Refer to FIG. 1. FIG. 1 is a schematic module diagram of an energy storage device 100 according to an embodiment of this application. As shown in FIG. 1, the energy storage device 100 includes an energy storage battery 110, an input switch K1, and a direct current voltage converter 120. An input terminal of the direct current voltage converter 120 is connected to an input power supply 200 through the input switch K1, the input power supply 200 is configured to provide a direct current to the direct current voltage converter 120, the energy storage battery 110 is connected to an output terminal of the direct current voltage converter 120, and the direct current voltage converter 120 is configured to perform voltage conversion on the direct current before outputting the direct current.

It may be understood that, the direct current voltage converter 120 may perform voltage conversion on the direct current before outputting the direct current to the energy storage battery 110 to charge the energy storage battery 110, or may perform voltage conversion on the direct current before outputting the direct current to a direct current load (not shown in the figure) to supply power to the direct current load. The input switch K1 in this embodiment of this application may be a switch involving a mechanical action, such as a relay or a circuit breaker. The input switch K1 is configured to control input of the input power supply 200. When the input switch K1 is open, the input power supply 200 cannot provide the direct current to the direct current voltage converter 120. When the input switch K1 is closed, the input power supply 200 can provide the direct current to the direct current voltage converter 120.

As shown in FIG. 2, in some embodiments, the energy storage device 100 may further include an LLC resonant converter 130 and an inverter 140, and the output terminal of the direct current voltage converter 120 may be connected to the energy storage battery 110 through the LLC resonant converter 130. Specifically, the output terminal of the direct current voltage converter 120 is connected to one end of the LLC resonant converter 130, and the other end of the LLC resonant converter 130 is connected to the energy storage battery 110. In this way, the direct current from the input power supply 200 is provided to the energy storage battery 110 through the LLC resonant converter 130 after voltage conversion is performed on the direct current through the direct current voltage converter 120.

An input terminal of the inverter 140 may be connected to the output terminal of the direct current voltage converter 120 and the LLC resonant converter 130, and an output terminal of the inverter 140 may be configured to connect to a power grid 300 or an alternating current load (not shown in the figure). The inverter 140 may be configured to convert the direct current outputted by the direct current voltage converter 120 or a direct current outputted by the LLC resonant converter 130 into an alternating current, which is provided to the power grid 300 or supplied to the alternating current load. Alternatively, the inverter 140 may be configured to convert an alternating current from the power grid 300 into a direct current, which is then transferred through the LLC resonant converter 130 to charge the energy storage battery 110. The inverter 140 and the power grid 300 may be connected through a switch K2. When it is necessary to provide alternating current power to the power grid 300 or provide alternating current power by the power grid 300 to the inverter 140, the switch K2 is closed and then the inverter 140 is controlled to operate.

It should be understood that, the LLC resonant converter 130 is merely an exemplary example. In an actual application scenario, the LLC resonant converter 130 may also be replaced with a direct current voltage converter of another type.

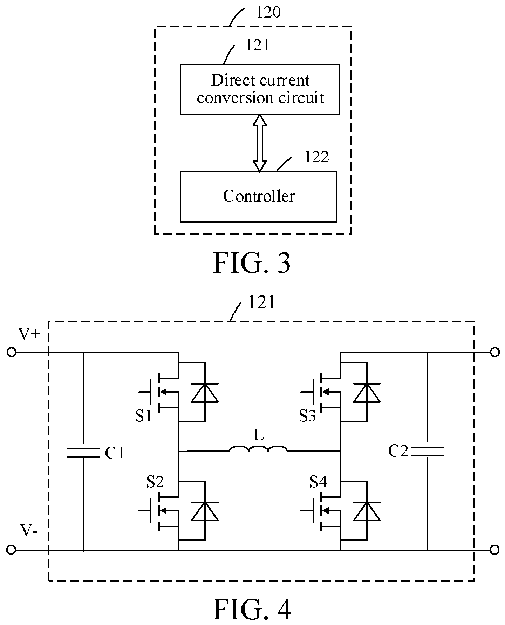

As shown in FIG. 3, in some embodiments, the direct current voltage converter 120 may include a direct current conversion circuit 121 and a controller 122. The direct current conversion circuit 121 includes a switching transistor. The controller 122 may be configured to control on and off of the switching transistor, to control the direct current conversion circuit 121 to perform voltage conversion on the direct current before outputting the direct current.

As shown in FIG. 4, in some embodiments, the direct current conversion circuit 121 may be a BUCK-BOOST circuit, and the direct current conversion circuit 121 may include a first switching transistor S1, a second switching transistor S2, a third switching transistor S3, a fourth switching transistor S4, an inductor L, a first capacitor C1, and a second capacitor C2. A first terminal of the first switching transistor S1 is connected to a positive terminal V+ of the input power supply 200, a second terminal of the first switching transistor S1 is connected to a first terminal of the second switching transistor S2 and a first terminal of the inductor L, and a second terminal of the second switching transistor S2 is connected to a negative terminal V- of the input power supply 200. A first terminal of the first capacitor C1 is connected to the positive terminal V+ of the input power supply 200, and a second terminal of the first capacitor C1 is connected to the negative terminal V- of the input power supply 200. A first terminal of the third switching transistor S3 is connected to a first terminal of the second capacitor C2 and serves as a first output terminal of the direct current conversion circuit 121. A second terminal of the third switching transistor S3 is connected to a first terminal of the fourth switching transistor S4 and a second terminal of the inductor L. A second terminal of the fourth switching transistor S4 is connected to a second terminal of the second capacitor C2 and serves as a second output terminal of the direct current conversion circuit 121. The first output terminal and the second output terminal of the direct current conversion circuit 121 serve as the output terminal of direct current voltage converter 120.

In this embodiment, when the direct current conversion circuit 121 operates normally, control terminals of the four switching transistors of the direct current conversion circuit receive corresponding driving signals, for example, pulse width modulation wave (Pulse Width Modulation Wave, PWM) signals of a preset frequency, and the switching transistors turn on or off based on the driving signals, thereby charging or discharging the inductor L, to implement voltage conversion on the direct current from the input power supply 200. A preset frequency of the driving signal is a switching frequency of the switching transistor.

Certainly, the direct current conversion circuit 121 in this embodiment of this application is not limited to the BUCK-BOOST circuit, and may alternatively be a BUCK circuit, a BOOST circuit, or the like as long as it can perform voltage conversion on the direct current before outputting the direct current.

In some embodiments, the input power supply 200 may be a photovoltaic panel, and the photovoltaic panel is configured to convert solar energy into electric energy provided to the energy storage device 100. Therefore, the photovoltaic panel and the energy storage device 100 jointly form a photovoltaic system.

In the photovoltaic system, an arc fault is easily caused by poor contact due to line aging or a loose cable joint. A direct current arc may easily cause an electric shock, equipment damage, or a fire hazard. Therefore, detecting whether a direct current arc fault occurs in the photovoltaic system is crucial for power supply safety of the photovoltaic system.

Currently, a current spectrum of the direct current is obtained generally through fast Fourier transform, and a harmonic amplitude of the direct current is compared with a preset threshold. When the amplitude exceeds the preset threshold, it is considered that a direct current arc fault has occurred in the photovoltaic system. However, the photovoltaic panel and the direct current voltage converter 120 are connected through the input switch K1. When the input switch K1 is the switch involving a mechanical action, closing the input switch K1 can also generate an arc. In this case, the photovoltaic system is in a normal state, and no arc fault has occurred. The current spectrum when the input switch K1 is closed is similar to a current spectrum during the arc fault, which may easily lead to false detection of an arc fault in the photovoltaic system when the input switch K1 is closed.

To resolve the problem, the existing solution is to set a large preset threshold to avoid false detection when the input switch K1 is closed. However, the large preset threshold may easily lead to failure to detect some direct current arc faults, which increases a probability of false detection and may cause a safety incident. In this way, it may be seen that, the existing arc fault detection method cannot distinguish between an arc caused by the closing of the input switch K1 and an arc fault, which may easily lead to false detection of the arc fault or missed detection of the direct current arc fault.

Certainly, the input power supply 200 of the energy storage device 100 provided in this embodiment of this application is not limited to the photovoltaic panel, and may alternatively be a direct current power supply of another type, such as a wind turbine or a diesel generator. As the input power supply 200 of the energy storage device 100, the direct current power supply of another type also has the foregoing problem.

To resolve the foregoing problem, this embodiment of this application provides the arc fault detection method, which can accurately determine whether an arc fault occurs in the direct current conversion circuit 121, to reduce false detection of the arc fault. In at least one embodiment, the arc fault detection method provided in this application may be performed by the controller 122.

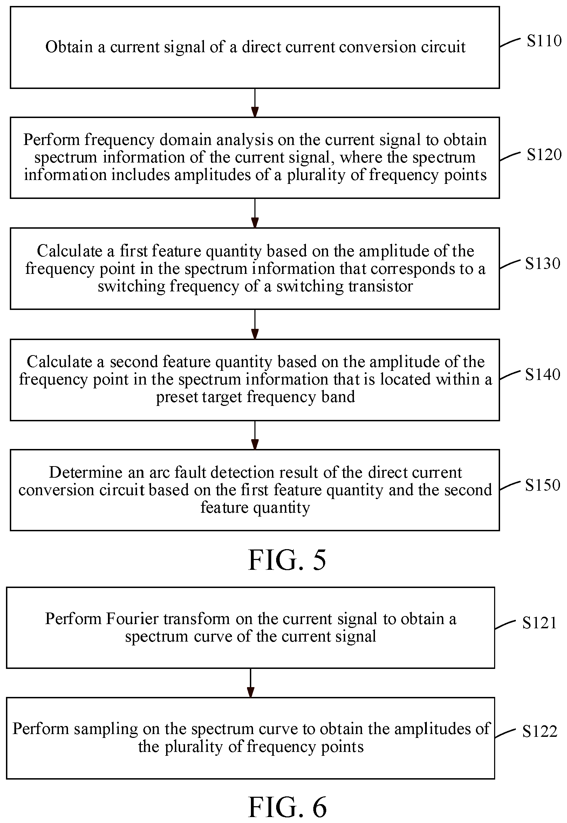

Refer to FIG. 5. FIG. 5 is a flowchart of an arc fault detection method according to an embodiment of this application. As shown in FIG. 5, the arc fault detection method includes the following steps S110 to S150.

S110: Obtain a current signal of a direct current conversion circuit.

Current sampling may be performed on the direct current conversion circuit 121 to obtain the current signal. A position for current sampling may be selected based on an actual requirement. Exemplarily, in the energy storage device 100 shown in FIG. 1 and FIG. 2, current sampling may be performed between the input switch K1 and the direct current conversion circuit 121 to obtain the current signal. In some other scenarios, current sampling may alternatively be performed at other positions. This is not limited in this application.

S120: Perform frequency domain analysis on the current signal to obtain spectrum information of the current signal, where the spectrum information includes amplitudes of a plurality of frequency points.

It may be understood that, by performing frequency domain analysis on the current signal obtained through current sampling on the direct current conversion circuit 121, a variation of the current signal in a time domain can be transformed into a variation of the current signal in a frequency domain to obtain the spectrum information of the current signal, in other words, current components at different frequency points included in the current signal and a relationship between an amplitude of each frequency point and an amplitude of a corresponding current component in the frequency domain.

S130: Calculate a first feature quantity based on the amplitude of the frequency point in the spectrum information that corresponds to a switching frequency of a switching transistor.

The switching frequency of the switching transistor is a frequency of a driving signal received by the switching transistor, and the first feature quantity is related to a current component at the frequency point corresponding to the switching frequency. Using the direct current conversion circuit 121 in FIG. 4 as an example, the switching frequency is a preset frequency of the driving signals received by the control terminals of the four switching transistors of the direct current conversion circuit 121. It may be understood that there may be one or more frequency points corresponding to the switching frequency of the switching transistors.

S140: Calculate a second feature quantity based on the amplitude of the frequency point in the spectrum information that is located within a preset target frequency band.

It may be understood that the target frequency band may include the frequency point corresponding to the switching frequency, or may not include the frequency point corresponding to the switching frequency. The target frequency band may be set based on actual application. For example, the target frequency band may be set based on a frequency band significantly affected when an arc fault occurs in the direct current conversion circuit 121. Alternatively, all frequency points in the spectrum information other than the frequency point corresponding to the switching frequency are used as frequency points within the target frequency band. Alternatively, all frequency points in the spectrum information are used as frequency points within the target frequency band. Alternatively, the target frequency band is set in other manners. The second feature quantity is related to an amplitude of a current component at the frequency point within the target frequency band in the frequency domain.

S150: Determine an arc fault detection result of the direct current conversion circuit based on the first feature quantity and the second feature quantity.

It may be understood that, when the input switch K1 in the energy storage device 100 is closed, because the switching transistor in the direct current conversion circuit 121 has not started to operate, a current component corresponding to the switching frequency in the current signal is small, that is, the first feature quantity is small. Closing the input switch K1 may cause generation of an arc in the direct current conversion circuit 121, which may easily lead to a large current component corresponding to the target frequency band in the spectrum information, that is, the second feature quantity is large. However, in this case, the direct current conversion circuit 121 is in a normal state and no arc fault has occurred.

When the input switch K1 is closed and the direct current conversion circuit 121 operates normally, the current component corresponding to the switching frequency in the current signal is large, that is, the first feature quantity is large, while the current component corresponding to the target frequency band is small, that is, the second feature quantity is small.

When the input switch K1 is closed and the direct current conversion circuit 121 operates normally, if an arc fault occurs, the current component corresponding to the target frequency band in the spectrum information increases, that is, the second feature quantity increases.

Based on the description of the above scenarios, it may be seen that the first feature quantity and the second feature quantity differ significantly in different scenarios. In this way, in the arc fault detection method in this embodiment of this application, the first feature quantity is calculated based on the amplitude of the frequency point in the spectrum information that corresponds to the switching frequency of the switching transistor, the second feature quantity is calculated based on the amplitude of the frequency point in the spectrum information that is located within the preset target frequency band, and whether an arc fault has occurred in the direct current conversion circuit 121 may be determined based on the first feature quantity and the second feature quantity. In addition, it is also possible to identify whether abnormality in the spectrum information is caused by the closing of the input switch K1, to prevent false detection of the arc fault due to the similarity between the spectrum information obtained when the input switch K1 is closed and the spectrum information during the arc fault. Therefore, this embodiment of this application can improve the accuracy of arc fault detection.

It may be understood that, step S150 may specifically include:
determining, when the first feature quantity is greater than a first threshold and the second feature quantity is greater than a second threshold, that an arc fault has occurred in the direct current conversion circuit; and
determining, when the first feature quantity is less than or equal to the first threshold or the second feature quantity is less than or equal to the second threshold, that no arc fault has occurred in the direct current conversion circuit.

The first threshold may be determined based on the amplitude of the frequency point corresponding to the switching frequency when the direct current conversion circuit 121 operates normally. The second threshold may be determined based on the amplitude of the frequency point corresponding to the target frequency band when an arc fault has occurred in the direct current conversion circuit 121.

Both the first threshold and the second threshold may be obtained through an experiment on the direct current conversion circuit 121. Exemplarily, the direct current conversion circuit 121 may be controlled to operate under the lowest stable operating condition (an operating condition in which the direct current conversion circuit 121 can maintain operation at the minimum output power). A current signal of the direct current conversion circuit 121 at this time is obtained, frequency domain analysis is performed on the current signal to obtain spectrum information, and a first upper limit value is calculated based on the amplitude of the frequency point in the spectrum information that corresponds to the switching frequency. Then, a current signal of the direct current conversion circuit 121 in a non-operating state is obtained, frequency domain analysis is performed on the current signal to obtain spectrum information, and a first lower limit value is calculated based on the amplitude of the frequency point in the spectrum information that corresponds to the switching frequency. A value between the first lower limit value and the first upper limit value is selected as the first threshold. For example, assuming that experimental results show that the first upper limit value is 10000 and the first lower limit value is 3000, 7000 may be selected as the first threshold. Certainly, specific values of the first upper limit value and the first lower limit value are determined based on an actual experiment and are not limited thereto. Selection of the first threshold may also be determined based on an actual requirement and is also not limited thereto.

In this way, when the first feature quantity is greater than the first threshold, the amplitude of the current component corresponding to the switching frequency in the current signal is large, that is, the switching transistor of the direct current conversion circuit 121 turns on/off at the switching frequency, which indicates that the direct current conversion circuit 121 is in an operating state. When the first feature quantity is less than or equal to the first threshold, the amplitude of the current component corresponding to the switching frequency in the current signal is small, which indicates that the direct current conversion circuit 121 is not in the operating state.

Correspondingly, the direct current conversion circuit 121 may be controlled to operate under the highest stable operating condition (an operating condition in which the direct current conversion circuit 121 can operate normally at the maximum output power). A current signal of the direct current conversion circuit 121 at this time is obtained, frequency domain analysis is performed on the current signal to obtain spectrum information, and a feature quantity is calculated based on the amplitude of the frequency point in the spectrum information that is located within the target frequency band. A 100% margin is added to the feature quantity to obtain a second lower limit value. Then, when the direct current conversion circuit 121 is controlled to operate under the highest stable operating condition, an arc fault occurs in the direct current conversion circuit 121 (for example, the connection between the input power supply 200 and the direct current conversion circuit 121 may be destabilized). A current signal of the direct current conversion circuit 121 at this time is obtained, frequency domain analysis is performed on the current signal to obtain spectrum information, and a second upper limit value is calculated based on the amplitude of the frequency point in the spectrum information that is located within the target frequency band. A value between the second lower limit value and the second upper limit value is selected as the second threshold. For example, assuming that experimental results show that the second lower limit value is 106 and the second upper limit value is 107, 5*106 may be selected as the second threshold. Certainly, specific values of the second upper limit value and the second lower limit value are determined based on an actual experiment and are not limited thereto. Selection of the second threshold may also be determined based on an actual requirement and is also not limited thereto.

In this way, when the second feature quantity is greater than the second threshold, it indicates that an arc may be generated in the direct current conversion circuit 121. When the second feature quantity is less than or equal to the second threshold, it indicates that no arc fault has occurred in the direct current conversion circuit 121.

In step S150, by comparing the first feature quantity with the first threshold and comparing the second feature quantity with the second threshold, when the first feature quantity is greater than the first threshold and the second feature quantity is greater than the second threshold, it indicates that the direct current conversion circuit 121 is in an operating state and an arc may occur. The direct current conversion circuit 121 being in the operating state indicates that the input switch K1 has been closed. Therefore, it can be determined that the arc at this time is not generated due to the closing of the input switch K1, and it can be further determined that an arc fault has occurred in the direct current conversion circuit 121.

When the first feature quantity is less than or equal to the first threshold and the second feature quantity is greater than the second threshold, it indicates that the direct current conversion circuit 121 is not in the operating state. However, based on the second feature quantity, it is determined that an arc is generated in the direct current conversion circuit 121. Therefore, it can be determined that the arc at this time is generated due to the closing of the input switch K1, and it can be further determined that no arc fault has occurred in the direct current conversion circuit 121.

When the second feature quantity is less than or equal to the second threshold, regardless of whether the first feature quantity is greater than the first threshold or less than or equal to the first threshold, it can indicate that no arc fault has occurred in the direct current conversion circuit 121.

In summary, in this embodiment, by combining the first feature quantity and the second feature quantity, it is possible to determine whether the arc generated in the direct current conversion circuit 121 is caused by the closing of the input switch K1. In this way, false detection of the arc fault in the direct current conversion circuit 121 when the input switch K1 is closed can be avoided, thereby improving the accuracy of determining the arc fault.

As shown in FIG. 6, in some embodiments, step S120 may include the following steps.

S121: Perform Fourier transform on the current signal to obtain a spectrum curve of the current signal.

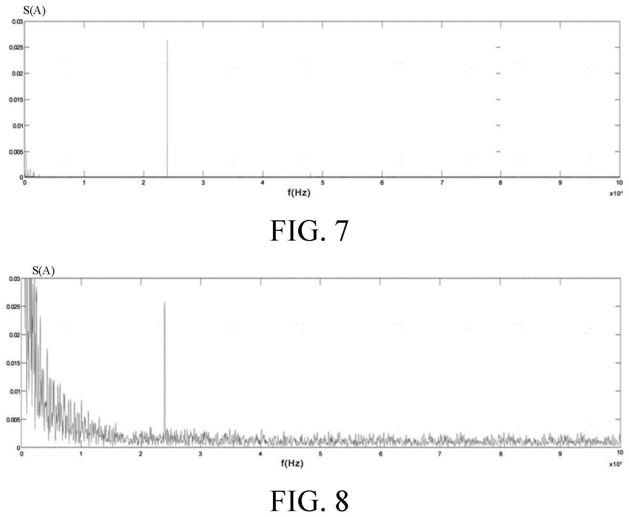

Refer to FIG. 7 and FIG. 8. FIG. 7 is a spectrum curve obtained by performing Fourier transform on the current signal obtained by performing current sampling on the direct current conversion circuit 121 when the direct current conversion circuit 121 operates normally. A horizontal axis represents frequency (unit: Hz, Hertz), and a vertical axis represents amplitude (unit: A, Ampere). FIG. 8 is a spectrum curve obtained by performing Fourier transform on the current signal obtained by performing current sampling on the direct current conversion circuit 121 when an arc fault has occurred in the direct current conversion circuit 121. A horizontal axis represents frequency (unit: Hz), and a vertical axis represents amplitude (unit: A).

It may be learned from FIG. 7 that, when the direct current conversion circuit 121 operates normally, if the switching transistor in the direct current conversion circuit 121 turns on and off at a switching frequency of 24 kHz (2.4*104 Hz), a harmonic corresponding to the switching frequency is generated. Therefore, the amplitude at 24 kHz in the spectrum curve is high. It may be learned from FIG. 8 that, when an arc fault occurs in the direct current conversion circuit 121, a large number of harmonics at different frequencies occur in the current signal, causing variations in amplitudes of a large number of frequency points in the spectrum curve, such as a frequency point of 10 kHz (namely, 1*104 Hz) and nearby frequency points.

In an actual application process, a proper current sampling frequency may be selected based on an actual requirement. For example, in some embodiments, current sampling may be performed by using a current sampling frequency of 200 kHz. In some other embodiments, current sampling may also be performed by using other current sampling frequencies. This is not limited in this application.

S122: Perform sampling on the spectrum curve to obtain the amplitudes of the plurality of frequency points.

According to FIG. 7 and FIG. 8, a spectrum curve is a curve chart of a relationship between an amplitude of each frequency point obtained by performing Fourier transform on the current signal and an amplitude of a corresponding current component. Therefore, the amplitudes of the plurality of frequency points can be obtained by performing sampling on the spectrum curve.

Using FIG. 8 as an example, a frequency range of the spectrum curve is 0-100 kHz. 512 frequency points may be collected from the spectrum curve, and the collected frequency points may be numbered in sequence.

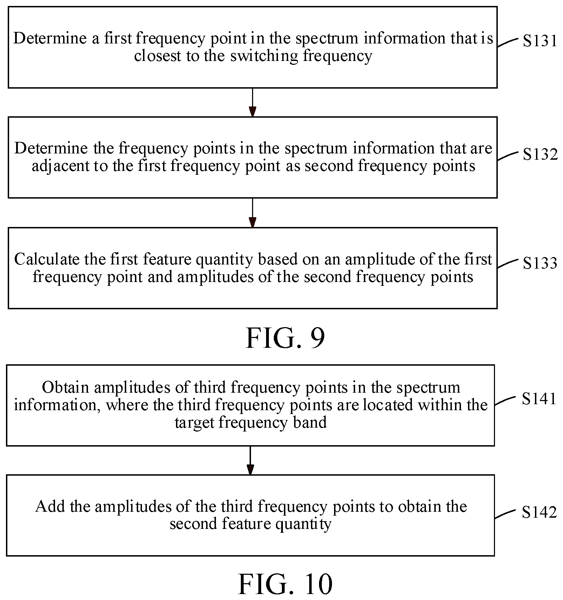

As shown in FIG. 9, in some embodiments, step S130 may include the following steps.

S131: Determine a first frequency point in the spectrum information that is closest to the switching frequency.

Using the spectrum curve shown in FIG. 8 as an example, a frequency span between adjacent frequency points can be obtained by dividing the frequency range by 512, and then a sequence number of the first frequency point can be obtained by dividing the switching frequency by the frequency span. Assuming that the frequency range of the spectrum curve is 0-100 kHz, and the switching frequency is 24 kHz, the frequency span is 100*103/512=195.3125 Hz. The sequence number of the first frequency point is 24*103/195.3125=122.88≈123. In other words, the 123rd frequency point in the collected 512 frequency points is the first frequency point closest to the switching frequency.

S132: Determine the frequency points in the spectrum information that are adjacent to the first frequency point as second frequency points.

In some embodiments, the frequency points adjacent to the first frequency point may be understood as the frequency point before the first frequency point and the frequency point after the first frequency point. For example, the second frequency points may include the 122nd frequency point and the 124th frequency point.

In some other embodiments, the frequency points adjacent to the first frequency point may be understood as a plurality of frequency points around the first frequency point, such as the two frequency points before the first frequency point and the two frequency points after the first frequency point.

S133: Calculate the first feature quantity based on the amplitude of the first frequency point and the amplitudes of the second frequency points.

Specifically, the amplitude of the first frequency point and the amplitudes of the second frequency points are added to obtain the first feature quantity.

For example, referring to the foregoing example, amplitudes of the 122nd frequency point, the 123rd frequency point, and the 124th frequency point in the spectrum curve may be added to obtain the first feature quantity.

Certainly, in some other embodiments, weighted processing may alternatively be performed on the amplitude of the first frequency point and the amplitudes of the second frequency points to obtain the first feature quantity through accumulation.

Exemplarily, as shown in FIG. 8, the amplitude of the first frequency point (the 123rd frequency point) is 0.025 A. When the current signal is a direct current, an amplitude of a current component obtained after Fourier transform is multiplied by 2, that is, an actual amplitude of the first frequency point is 0.05 A. If the amplitudes of the second frequency points (the 122nd frequency point and the 124th frequency point) are the same as the amplitude of the first frequency point, a sum of the amplitude of the first frequency point and the amplitudes of the second frequency points is 0.05*3=0.15 A. If the number of sampling points is 1024, and a weight coefficient is 50, the first feature quantity is 0.15*1024*50=7680. In some other scenarios, weighted processing may also be performed in other calculation manners. This is not limited in this application.

As shown in FIG. 10, in some embodiments, step S140 may include the following steps.

S141: Obtain amplitudes of third frequency points in the spectrum information, where the third frequency points are located within the target frequency band.

The third frequency points are all frequency points collected within the target frequency band. The target frequency band may refer to a frequency band in the spectrum curve that is significantly affected when an arc fault occurs, such as 0-10 kHz in FIG. 10. The target frequency band may alternatively refer to all frequency points within the frequency range of the spectrum curve other than the frequency point corresponding to the switching frequency, such as all frequency points other than the 122nd frequency point, the 123rd frequency point, and the 124th frequency point in FIG. 10.

S142: Add the amplitudes of the third frequency points to obtain the second feature quantity.

In some embodiments, after the amplitudes of the third frequency points are obtained, the amplitudes of the third frequency points may be added to obtain the second feature quantity.

In some other embodiments, weighted processing may also be performed on the amplitudes of the third frequency points to obtain the second feature quantity through accumulation.

It may be understood that a specific implementation of adding the amplitudes of the third frequency points to obtain the second feature quantity or performing weighted processing on the amplitudes of the third frequency points to obtain the second feature quantity through accumulation is the same or similar to the foregoing manner for calculating the first feature quantity, and is not described in detail herein again.

This application further provides an electronic device, including a controller and a memory. The memory stores executable instructions of the controller, and the controller is configured to perform the arc fault detection method described above by performing the executable instructions.

This application further provides a direct current voltage converter, including a direct current conversion circuit and a controller, where the direct current conversion circuit includes a switching transistor, and the controller is configured to perform the arc fault detection method described above.

This application further provides an energy storage device, including an energy storage battery, an input switch, and the direct current voltage converter described above, where an input terminal of the direct current voltage converter is connected to an input power supply through the input switch, the input power supply is configured to provide a direct current to the direct current voltage converter, the energy storage battery is connected to an output terminal of the direct current voltage converter, and the direct current voltage converter is configured to perform voltage conversion on the direct current before outputting the direct current.

This application further provides a computer-readable storage medium, storing a computer program, where the computer program, when executed by a controller, causes the arc fault detection method described above to be implemented.

The controller may be a central processing unit (Central Processing Unit, CPU), or may be another general purpose processor, a digital signal processor (Digital Signal Processor, DSP), an application-specific integrated circuit (Application Specific Integrated Circuit, ASIC), a field-programmable gate array (Field-Programmable Gate Array, FPGA) or another programmable logical device, a discrete gate, a transistor logic device, a discrete hardware component, or the like. The general-purpose processor may be a microprocessor, or the processor may be any conventional processor or the like.

A memory may be configured to store a computer program and/or module, and the controller implements various functions of the direct current voltage converter 120 or the energy storage device 100 by executing or obtaining the computer program and/or module stored in the memory and invoking data stored in the memory. The memory may mainly include a program storage area and a data storage area. The program storage area may store an operating system, an application program required by at least one function (for example, a power on/off function and a key processing function), and the like. The data storage area may store data created based on the use of the direct current voltage converter 120 or the energy storage device 100. In addition, the memory may include a non-volatile memory, such as a hard disk, an internal memory, a plug-in hard disk, a smart media card (Smart Media Card, SMC), a secure digital (Secure Digital, SD) card, a flash card (Flash Card), at least one disk storage device, a flash storage device, or another non-volatile solid-state storage device.

The memory may be an external memory and/or an internal memory of the direct current voltage converter 120 or the energy storage device 100. Further, the memory may be a physical memory, such as a memory module, a TF card (Trans-flash Card), or the like.

When program code and various types of data in the memory are implemented in a form of a software functional unit and sold or used as an independent product, the program code and various types of data may be stored in a computer-readable storage medium. Based on such understanding, all or some of the processes of the methods in the embodiments, for example, the arc fault detection method, may be implemented by a computer program instructing relevant hardware. The computer program may be stored in a computer-readable storage medium. During execution of the computer program by the controller, steps of the foregoing method embodiments may be implemented. The computer program includes computer program code. The computer program code may be in a source code form, an object code form, executable file or some intermediate forms, or the like. The computer-readable medium may include: any entity or apparatus that is capable of carrying the computer program code, a recording medium, a USB flash drive, a removable hard disk, a magnetic disk, an optical disc, a computer memory, a read-only memory (ROM, Read-Only Memory), and the like.

The embodiments of this application are described above in detail with reference to the accompanying drawings, but this application is not limited to the foregoing embodiments. Within the knowledge of a person of ordinary skill in the art, various variations may be made without departing from the scope of this application.

## Claims

1. An arc fault detection method for a direct current conversion circuit, wherein the direct current conversion circuit comprises a switching transistor; and the arc fault detection method comprises:
obtaining a current signal of the direct current conversion circuit;
performing frequency domain analysis on the current signal to obtain spectrum information of the current signal, wherein the spectrum information comprises amplitudes of a plurality of frequency points;
calculating a first feature quantity based on the amplitude of the frequency point in the spectrum information that corresponds to a switching frequency of the switching transistor;
calculating a second feature quantity based on the amplitude of the frequency point in the spectrum information that is located within a preset target frequency band; and
determining an arc fault detection result of the direct current conversion circuit based on the first feature quantity and the second feature quantity.

2. The arc fault detection method according to claim 1, wherein the determining an arc fault detection result of the direct current conversion circuit based on the first feature quantity and the second feature quantity comprises:
determining, when the first feature quantity is greater than a first threshold and the second feature quantity is greater than a second threshold, that an arc fault has occurred in the direct current conversion circuit.

3. The arc fault detection method according to claim 2, wherein the determining an arc fault detection result of the direct current conversion circuit based on the first feature quantity and the second feature quantity further comprises:
determining, when the first feature quantity is less than or equal to the first threshold or the second feature quantity is less than or equal to the second threshold, that no arc fault has occurred in the direct current conversion circuit.

4. The arc fault detection method according to any one of claims 1 to 3, wherein the performing frequency domain analysis on the current signal to obtain spectrum information of the current signal comprises:
performing Fourier transform on the current signal to obtain a spectrum curve of the current signal; and
performing sampling on the spectrum curve to obtain the amplitudes of the plurality of frequency points.

5. The arc fault detection method according to claim 4, wherein the calculating a first feature quantity based on the amplitude of the frequency point in the spectrum information that corresponds to a switching frequency of the switching transistor comprises:
determining a first frequency point in the spectrum information that is closest to the switching frequency;
determining the frequency points in the spectrum information that are adjacent to the first frequency point as second frequency points; and
calculating the first feature quantity based on an amplitude of the first frequency point and amplitudes of the second frequency points.

6. The arc fault detection method according to claim 5, wherein the calculating the first feature quantity based on an amplitude of the first frequency point and amplitudes of the second frequency points comprises:
adding the amplitude of the first frequency point and the amplitudes of the second frequency points to obtain the first feature quantity; or
performing weighted processing on the amplitude of the first frequency point and the amplitudes of the second frequency points to obtain the first feature quantity through accumulation.

7. The arc fault detection method according to claim 4, wherein the calculating a second feature quantity based on the amplitude of the frequency point in the spectrum information that is located within a preset target frequency band comprises:
obtaining amplitudes of third frequency points in the spectrum information, wherein the third frequency points are located within the target frequency band; and
adding the amplitudes of the third frequency points to obtain the second feature quantity; or performing weighted processing on the amplitudes of the third frequency points to obtain the second feature quantity through accumulation.

8. A direct current voltage converter, comprising a direct current conversion circuit and a controller, wherein the direct current conversion circuit comprises a switching transistor, and the controller is configured to perform the arc fault detection method according to any one of claims 1 to 7.

9. An energy storage device, comprising an energy storage battery, an input switch, and the direct current voltage converter according to claim 8, wherein an input terminal of the direct current voltage converter is connected to an input power supply through the input switch, the input power supply is configured to provide a direct current to the direct current voltage converter, the energy storage battery is connected to an output terminal of the direct current voltage converter, and the direct current voltage converter is configured to perform voltage conversion on the direct current before outputting the direct current.

10. A computer-readable storage medium, storing a computer program, wherein the computer program, when executed by a controller, causes the arc fault detection method according to any one of claims 1 to 7 to be implemented.
